Europäisches Patentamt

European Patent Office

Office européen des brevets

(11) Veröffentlichungsnummer: **0 111 734**
**B1**

# EUROPÄISCHE PATENTSCHRIFT

(45) Veröffentlichungstag der Patentschrift:
26.08.87

(21) Anmeldenummer: 83111255.2

(22) Anmeldetag: 11.11.83

(51) Int. Cl.⁴: **G 02 F 1/133**, H 05 K 3/30,
H 05 K 13/00

(54) **Verfahren zum Herstellen einer Flüssigkristall-Anzeigevorrichtung.**

(30) Priorität: 23.11.82 DE 3243227

(43) Veröffentlichungstag der Anmeldung:
27.06.84 Patentblatt 84/26

(45) Bekanntmachung des Hinweises auf die Patenterteilung:
26.08.87 Patentblatt 87/35

(84) Benannte Vertragsstaaten:
DE FR GB IT

(56) Entgegenhaltungen:
EP - A - 0 022 934
CH - A - 624 525
DE - A - 3 105 981
GB - A - 2 052 779
GB - A - 2 085 632
US - A - 4 054 238
US - A - 4 157 932

(73) Patentinhaber: Licentia Patent-Verwaltungs-GmbH,
Theodor-Stern-Kai 1, D-6000 Frankfurt/Main 70 (DE)

(72) Erfinder: Fahrenschon, Kurt, Dipl.-Phys.,
Hirschstrasse 8, D-7914 Pfaffenhofen (DE)
Erfinder: Wiemer, Wolfram, Dipl.-Phys. Dr. rer. nat.,
Fliederweg 12, D-7906 Blaustein (DE)

(74) Vertreter: Amersbach, Werner, Dipl.-Ing. et al, Licentia
Patent-Verwaltungs-GmbH Theodor-Stern-Kai 1,
D-6000 Frankfurt 70 (DE)

**Beschreibung**

Die vorliegende Erfindung betrifft ein Verfahren zum Herstellen einer Flüssigkristall-Anzeige-Vorrichtung in flexibler Folientechnik mit integrierten elektronischen Schaltkreisen (IC).

Es ist bereits bekannt, grossflächige Flüssigkristall-Anzeigezellen in Kunststofftechnik herzustellen. Es ist weiter bekannt, auf Flüssigkristall-Anzeigezellen Ansteuerbausteine in Form von integrierten Schaltungen (IC) auf einer der grossflächigen Oberflächen dieser Flüssigkristall-Anzeigezellen direkt zu befestigen und die Anschlüsse dieser Schaltungsbausteine mit entsprechenden Leitungsbahnen der Flüssigkristallzelle zu verbinden (siehe DE-A-3 105 981).

Das Anbringen von IC-Bausteinen auf Flüssigkristall-Anzeigen, die in flexibler Folientechnik hergestellt sind, ist jedoch mit gewissen Schwierigkeiten verbunden, insbesondere was die Positionierung der IC-Bausteine und das Herstellen haltbarer Verbindungen betrifft. Lötvorgänge scheiden wegen der Wärmeempfindlichkeit der Folienmaterialien weitgehend aus.

Der vorliegenden Erfindung liegt die Aufgabe zugrunde, ein Verfahren zum Herstellen von in Folientechnik hergestellten Flüssigkristall-Anzeige-Einheiten anzugeben, wobei diese Flüssigkristall-Anzeige-Einheit sowohl eine grossflächige Flüssigkristall-Anzeigezelle als auch darauf aufgebrachte IC-Bausteine umfasst.

Diese Aufgabe wird gemäss der Erfindung dadurch gelöst, dass die IC's zunächst auf einem mit elektrischen Leiterbahnen versehenen flexiblen Band befestigt, kontaktiert und mittels der Leiterbahnen verschaltet werden, dass dann Abschnitte von diesem Band mit den darauf verschalteten IC's und frei überstehenden, zum Kontaktieren vorgesehenen Leiterbahnteilen durch Schneiden oder Stanzen gebildet werden, dass dann ein oder mehrere solcher Bandabschnitte derart auf in Folientechnik hergestellten Flüssigkristallzellen positioniert werden, dass die frei überstehenden Leiterbahnteile auf der Flüssigkristallzelle befindliche Leiterbahnen kontaktieren und dass dann die Bandabschnitte auf der Flüssigkristallzelle befestigt werden.

Das beschriebene Verfahren eignet sich besonders zur Herstellung von Flüssigkristall-Anzeige-Einheiten in flexibler Kunststoff-Folien-Technik. Es ist besonders geeignet für automatische Fertigungs- und Herstellungsprozesse. Im nachfolgenden wird der Anmeldungsgegenstand näher beschrieben.

Zunächst wird eine Flüssigkristall-Anzeigezelle in Kunststofftechnik hergestellt. Die dazu verwendeten flexiblen Deckfolien, die mit entsprechenden elektrischen Leiterbahnen versehen sind, werden zweckmässig direkt von einer Rolle verarbeitet. Nach Fertigstellung können diese Zellen am Rand exakt beschnitten werden. Um nun äussere Schaltungselemente, insbesondere IC-Bausteine, auf dieser flexiblen Flüssigkristall-Anzeigezelle anzubringen, werden zunächst die IC-Bausteine in einer Filmmontagetechnik auf ein wärmebeständiges Band aufgebracht. Dieses wärmebeständige Band enthält bereits entsprechende elektrische Leitungsbahnen, z.B. geätzte Kupferbahnen auf einem wärmebeständigen flexiblen Kunststoffmaterial. Die einzelnen Anschlüsse der IC-Bausteine, die auf diesen Bändern befestigt und mit den Leitungsbahnen verbunden werden, sind durch die entsprechenden Leitungsbahnen bereits untereinander verschaltet. Man hat gewissermassen nunmehr eine flexible Leiterplatte mit darauf befindlichen bereits verschalteten IC-Bausteinen.

Von diesem Band werden nun die entsprechenden Teile jeweils abgeschnitten und die Abschnitte so ausgebildet, dass frei abstehende Leiterbahnenenden vorhanden sind. Dies wird beispielsweise dadurch erreicht, dass das Trägerband aus flexiblem Kunststoff Durchbrüche aufweist, die von freitragenden Leiterbahnen überbrückt werden. Wird nun eine Stanzlinie durch eine solche Öffnung hindurchgelegt, so erhält man in diesem Bereich frei abstehende Enden von Leitungsbahnen, die der weiteren Kontaktierung dienen können.

Die nunmehr vorhandenen Leiterbahnabschnitte mit den darauf befindlichen IC-Bausteinen und den frei abstehenden Leiterbahnenenden werden nun an den entsprechenden Stellen auf der Flüssigkristall-Anzeigezelle positioniert, und zwar dersat, dass die frei abstehenden Leiterbahnenenden die entsprechenden vorgesehenen Leiterbahnabschnitte auf der Oberfläche der Flüssigkristall-Anzeigezelle kontaktieren. Die genaue Positionierung erfolgt zweckmässig im Zuge automatischer Fertigungseinrichtungen unter Zuhilfenahme von optischen oder mechanischen Markierungen, z.B. in Form von Indexöffnungen.

Die auf der richtigen Stelle der Flüssigkristall-Anzeigezelle positionierten Bandabschnitte werden mit den IC's dann an der Flüssigkristallzelle befestigt, was zweckmässig mit Hilfe einer Klemmvorrichtung oder mit Hilfe eines Klebers erfolgt.

Die Kontaktverbindungen zwischen den überstehenden Leiterbahnenenden des Bandabschnittes und den entsprechenden Leiterbahnstellen auf der Flüssigkristallzelle erfolgen ebenfalls mit Hilfe eines in diesem Fall elektrisch leitfähigen Klebers oder aber durch Anpressen mit Hilfe einer Klemmvorrichtung.

**Patentansprüche**

1. Verfahren zum Herstellen einer Flüssigkristall-Anzeigevorrichtung in flexibler Folientechnik mit integrierten elektronischen Schaltkreisen (IC), dadurch gekennzeichnet, dass die IC's zunächst auf einem mit elektrischen Leiterbahnen versehenen flexiblen Band befestigt, kontaktiert und mittels der Leiterbahnen verschaltet werden, dass dann Abschnitte von diesem Band mit den darauf verschalteten IC's und frei überstehenden, zum Kontaktieren vorgesehenen Leiterbahnteilen durch Schneiden oder Stanzen gebil-

det werden, dass dann ein oder mehrere solcher Bandabschnitte derart auf in Folientechnik hergestellten Flüssigkristallzellen positioniert werden, dass die frei überstehenden Leiterbahnteile auf der Flüssigkristallzelle befindliche Leiterbahnen kontaktieren und dass dann die Bandabschnitte auf der Flüssigkristallzelle befestigt werden.

2. Verfahren nach Anspruch 1, dadurch gekennzeichnet, dass die Bandabschnitte auf der Flüssigkristallzelle durch Klemmen befestigt werden.

3. Verfahren nach Anspruch 1, dadurch gekennzeichnet, dass die Bandabschnitte auf der Flüssigkristallzelle durch Kleben befestigt werden.

4. Verfahren nach einem der Ansprüche 1 bis 3, dadurch gekennzeichnet, dass die elektrischen Leiterbahnen der Flüssigkristallzelle und des Bandabschnittes mittels eines elektrisch leitenden Klebers miteinander verbunden werden.

5. Verfahren nach einem der Ansprüche 1 bis 4, dadurch gekennzeichnet, dass die Positionierung der Bandabschnitte auf der Flüssigkristallzelle unter Zuhilfenahme von optisch und/oder mechanisch wirkenden Markierungen, wie z.B. Indexöffnungen, vorgenommen wird.

6. Verfahren nach Anspruch 5, dadurch gekennzeichnet, dass die Markierungen auf den Bandabschnitten und/oder den Flüssigkristallzellen angeordnet sind.

## Claims

1. Method of manufacturing a liquid crystal display device in flexible film technique with integrated electronic switching circuits (IC), characterised thereby, that the integrated electronic switching circuits are initially fastened on a flexible tape provided with electrical conductor tracks, made contact with and wired by means of the conductor tracks, that portions of this tape with the integrated electronic switching circuits wired thereon and freely projecting conductor track parts provided for making contact are then formed by cutting or stamping, that one or more such tape portions are then positioned in such a manner on liquid crystal cells manufactured in film technique that the freely projecting conductor track parts make contact with conductor tracks disposed on the liquid crystal cell and that the tape portions are then fastened on the liquid crystal cell.

2. Method according to claim 1, characterised thereby, that the tape portions are fastened on the liquid crystal cell by clamping.

3. Method according to claim 1, characterised thereby, that the tape portions are fastened on the liquid crystal cell by gluing.

4. Method according to one of the claims 1 to 3, characterised thereby, that the electrical conductor tracks of the liquid crystal cell and of the tape portion are then connected one with the other by means of an electrically conductive adhesive substance.

5. Method according to one of the claims 1 to 4, characterised thereby, that the positioning of the tape portions on the liquid crystal cell is undertaken with the aid of optically and/or mechanically effective markings, such as for example index openings.

6. Method according to claim 5, characterised thereby, that the markings are arranged on the tape portions and/or the liquid crystal cells.

## Revendications

1. Procédé pour fabriquer un afficheur à cristaux liquides selon la technique à feuille souple, avec des circuits électroniques intégrés (CI), caractérisé en ce que, pour commencer, on fixe les CI sur un ruban souple pourvu de pistes conductives électriques, on met les CI en contact avec ces pistes, en les interconnectant ainsi dans un montage, on forme ensuite, notamment par découpage, des tronçons de ce ruban, qui portent les CI montés et présentent des parties de pistes dépassant librement et destinées à la mise en contact, on positionne, après cela, un ou plusieurs de ces tronçons de ruban sur des cellules de cristal liquide, produites selon la technique à feuille souple, de manière que les parties de pistes dépassant librement viennent en contact avec les pistes conductives situées sur la cellule de cristal liquide, puis on fixe les tronçons de ruban sur la cellule de cristal liquide.

2. Procédé selon la revendication 1, caractérisé en ce que l'on fixe les tronçons de ruban sur la cellule de cristal liquide par serrage.

3. Procédé selon la revendication 1, caractérisé en ce que l'on fixe les tronçons de ruban sur la cellule de cristal liquide par collage.

4. Procédé selon une des revendications 1 à 3, caractérisé en ce que l'on relie les pistes conductives électriques de la cellule de cristal liquide et du tronçon de ruban au moyen d'un adhésif conducteur électrique.

5. Procédé selon une des revendications 1 à 4, caractérisé en ce que l'on effectue le positionnement des tronçons de ruban sur la cellule de cristal liquide à l'aide de repères optiques et/ou mécaniques, par exemple à l'aide de trous de repérage.

6. Procédé selon la revendication 5, caractérisé en ce que les repères sont disposés sur les tronçons de ruban et/ou sur les cellules de cristal liquide.